# EUROPEAN PATENT APPLICATION

(11) **EP 2 403 023 A1**
(43) Date of publication of application: **04.01.2012**
(21) Application number: 10746044.6
(22) Date of filing: 27.01.2010
(51) Int. Cl.: H01L 33/32, H01L 21/205, H01S 5/343

(54) **LIGHT EMITTING ELEMENT PRODUCING METHOD AND LIGHT EMITTING ELEMENT**

(30) Priority: 24.02.2009 JP 2009041159
(71) Applicant: Sumitomo Electric Industries, Ltd., Chuo-ku Osaka-shi Osaka 541-0041 (JP)
(72) Inventor: YOSHIZUMI, Yusuke, Itami-shi Hyogo 664-0016 (JP); UENO, Masaki, Itami-shi Hyogo 664-0016 (JP); NAKAMURA, Takao, Itami-shi Hyogo 664-0016 (JP); UEDA, Toshio, Itami-shi Hyogo 664-0016 (JP); TAKASUKA, Eiryou, Itami-shi Hyogo 664-0016 (JP); SENDA, Yasuhiko, Itami-shi Hyogo 664-0016 (JP)
(74) Representative: Grünecker, Kinkeldey, Stockmair & Schwanhäusser
(86) International application number: PCT/JP2010/051029
(87) International publication number: WO 2010/098163

(57) **Abstract**

A method for manufacturing a light emitting element is directed to a method for manufacturing a light emitting element of a III-V group compound semiconductor having a quantum well structure including In and N, including the steps of: forming a well layer (13a) including In and N; forming a barrier layer (13b) having a bandgap wider than a bandgap of the well layer (13a); and supplying a gas including N and interrupting epitaxial growth after the step of forming the well layer (13a) and before the step of forming the barrier layer (13b). In the step of interrupting epitaxial growth, the gas having decomposition efficiency higher than decomposition efficiency of decomposition from N₂ and NH₃ into active nitrogen at 900°C is supplied. In addition, in the step of interrupting epitaxial growth, the gas different from a gas used as an N source of the well layer (13a) is supplied.

## Description

### TECHNICAL FIELD

The present invention relates to a method for manufacturing a light emitting element and the light emitting element. More particularly, the present invention relates to a method for manufacturing a light emitting element of a III-V group compound semiconductor having a quantum well structure including In (indium) and N (nitrogen), and the light emitting element.

### BACKGROUND ART

A III-V group compound semiconductor configured by GaN (gallium nitride), AIN (aluminum nitride) and InN (indium nitride), as well as a ternary mixed crystal thereof, that is, Al₍₁₋ₓ₎GaₓN (0<x<1) (hereinafter also referred to as AlGaN), In₍₁₋ₓ₎GaₓN (0<x<1) (hereinafter also referred to as InGaN) and In₍₁₋ₓ₎AlₓN (0<x<1) (hereinafter also referred to as AlInN), or a quaternary mixed crystal thereof, that is, In_{(1-x-y)}AlₓGa_{y}N (0<x<1, 0<y<1, x+y<1) (hereinafter referred to as InAlGaN) has been conventionally used in a green, blue or white LED (Light Emitting Diode), a bluish-violet LD (Laser Diode) and the like.

Japanese Patent Laying-Open No. 2007-324546 (Patent Document 1) discloses, as the light emitting element as described above, a method for manufacturing a GaN-based compound semiconductor light emitting element including a light emitting layer that has a well layer formed of a GaN-based compound semiconductor including In (indium) and a barrier layer formed of a GaN-based compound semiconductor. This Patent Document 1 discloses the following.

Specifically, as the composition of In included in the well layer increases, the wavelength of light emission becomes long, and a green light emission wavelength of, for example, 490 nm or more is obtained. In order to increase the composition of In included in the well layer, the growth temperature must be lowered. Furthermore, the barrier layer must be grown at higher temperature as compared with the well layer. Therefore, there is a relationship of T1≤T2 between a temperature T1 at which the well layer is grown and a temperature T2 at which the barrier layer is formed, when the light emitting layer is formed.

### PRIOR ART DOCUMENTS

### PATENT DOCUMENTS

Patent Document 1: Japanese Patent Laying-Open No. 2007-324546

### SUMMARY OF THE INVENTION

### PROBLEMS TO BE SOLVED BY THE INVENTION

The inventors of the present invention have found that in the method for manufacturing a GaN-based compound semiconductor light emitting element disclosed in Patent Document 1, steps of forming the light emitting layer have the following problems. Figs. 7 to 11 are cross-sectional views for describing a method for forming the light emitting layer having a quantum well structure including In and N (nitrogen) as disclosed in above Patent Document 1. As shown in Fig. 7, when a well layer 113a is formed on a barrier layer 113 b at growth temperature T1, a surface of well layer 113a becomes flat. When the temperature is raised to growth temperature T2 to form barrier layer 113b, however, irregularities are created on the surface of well layer 113a as shown in Fig. 8 and the composition of In decreases. Consequently, as shown in Fig. 9, barrier layer 113b is formed on well layer 113a having the irregularities formed on the surface thereof. Thereafter, the temperature is reduced to growth temperature T1, and well layer 113a is formed as shown in Fig. 10. When the temperature is raised to growth temperature T2 to form barrier layer 113b, however, irregularities are created on a surface of well layer 113a as shown in Fig. 11 and the composition of In decreases.

As described above, in the method for manufacturing a GaN-based compound semiconductor light emitting element disclosed in above Patent Document 1 as well, when the temperature is raised from temperature T1 at which well layer 113a is formed to temperature T2 at which barrier layer 113b is formed, the composition of In in well layer 113a decreases. There is a problem that as a result of the decrease in composition of In in well layer 113a, a long-wavelength light emitting element cannot be obtained. In addition, there is a problem that as a result of the irregularities formed on the surface of well layer 113a, light emission properties decrease.

Thus, an object of the present invention is to provide a method for manufacturing a long-wavelength light emitting element having enhanced light emission properties, and the light emitting element.

### MEANS FOR SOLVING THE PROBLEMS

The inventors of the present invention have found, as a result of their earnest study, the factors in the formation of the irregularities on the surface of well layer 113a and the decrease in composition of In in the method for manufacturing a GaN-based compound semiconductor light emitting element disclosed in above Patent Document 1. In other words, the inventors of the present invention have found that decomposition in well layer 113a is caused because the step of raising the temperature to form barrier layer 113b after well layer 113a is formed takes a long time or the temperature maintained until barrier layer 113b is fully grown is high.

Thus, the inventors of the present invention have focused on the fact that In thermally decomposes and vaporizes at a low temperature in the III-V group compound semiconductor including In because bonding between In and N is weak, and have earnestly studied the atmosphere in a step of interruption. Consequently, the inventors of the present invention have found the present invention that will be described below.

In other words, a method for manufacturing a light emitting element in one aspect of the present invention is directed to a method for manufacturing a light emitting element of a III-V group compound semiconductor having a quantum well structure including In and N, including the steps of: forming a well layer including In and N; forming a barrier layer including N and having a bandgap wider than a bandgap of the well layer; and interrupting epitaxial growth by supplying a gas including N after the step of forming the well layer and before the step of forming the barrier layer. In the step of interrupting epitaxial growth, the gas having decomposition efficiency higher than decomposition efficiency of decomposition from N₂ (nitrogen) and NH₃ (ammonia) into active nitrogen at 900°C is supplied.

According to the method for manufacturing a light emitting element in one aspect of the present invention, the gas having decomposition efficiency higher than decomposition efficiency of decomposition into the active nitrogen is supplied in the step of interrupting epitaxial growth. Therefore, epitaxial growth is interrupted in the atmosphere including the active nitrogen. As a result, separation of In and N that configure the well layer can be suppressed. Furthermore, even if In and N that configure the well layer separate, N is taken into the well layer by the active nitrogen in the atmosphere. Therefore, desorption of N that configures the well layer in the step of interrupting epitaxial growth can be suppressed. Accordingly, formation of irregularities on a surface of the well layer and decrease in composition of In after the well layer is formed and until the barrier layer is formed can be suppressed. Thus, a long-wavelength light emitting element having enhanced light emission properties can be manufactured.

A method for manufacturing a light emitting element in another aspect of the present invention is directed to a method for manufacturing a light emitting element of a III-V group compound semiconductor having a quantum well structure including In and N, including the steps of: forming a well layer including In and N; forming a barrier layer including N and having a bandgap wider than a bandgap of the well layer; and interrupting epitaxial growth by supplying a gas including N after the step of forming the well layer and before the step of forming the barrier layer. In the step of interrupting epitaxial growth, the gas different from a gas used as N sources of the well layer and the barrier layer is supplied.

According to the method for manufacturing a light emitting element in another aspect of the present invention, the gas different from the gas used as the N sources of the well layer and the barrier layer is supplied in the step of interrupting epitaxial growth. The atmosphere in the step of forming the well layer and the step of forming the barrier layer is different from the atmosphere in the step of interrupting epitaxial growth for the reason that a material is not flown, for example. Thus, by supplying the gas different from the gas used as the N sources of the well layer and the barrier layer in the step of interrupting epitaxial growth, separation of In and N that configure the well layer can be suppressed, and N can be refilled when In and N that configure the well layer separate. Therefore, desorption of N that configures the well layer in the step of interrupting epitaxial growth can be suppressed. Accordingly, formation of irregularities on the surface of the well layer and decrease in composition of In after the well layer is formed and until the barrier layer is formed can be suppressed. Thus, a long-wavelength light emitting element having enhanced light emission properties can be manufactured.

In particular, both the N source of the well layer and the gas different from the gas used as this N source are preferably supplied in the step of interrupting epitaxial growth. In this case, even if the conditions and the like for easy decomposition into the active nitrogen vary, there is a higher probability that either the N source or the gas decomposes into the active nitrogen. Therefore, desorption ofN that configures the well layer can be further suppressed.

Preferably, in the method for manufacturing a light emitting element in above one and another aspects, in the step of interrupting epitaxial growth, the gas including at least one of monomethylamine (CH₅N) and monoethylamine (C₂H₇N) is supplied.

The inventors of the present invention have found, as a result of their earnest study, that monomethylamine and monoethylamine can supply the active nitrogen that contributes to growth efficiently even at a low temperature. Therefore, the atmosphere including the larger amount of the active nitrogen can be formed in the step of interrupting epitaxial growth, and thus, desorption ofN that configures the well layer can be effectively suppressed. Thus, a long-wavelength light emitting element having enhanced light emission properties can be manufactured.

Preferably, in the method for manufacturing a light emitting element in above one and another aspects, in the step of interrupting epitaxial growth, the gas including ammonia (NH₃) and at least one of monomethylamine and monoethylamine having a concentration of a hundredth or less of a concentration of NH₃ is supplied.

As a result, due to monomethylamine and monoethylamine that contribute to growth efficiently even at a low temperature, the atmosphere including the larger amount of the active nitrogen can be formed. Furthermore, when NH₃ is used as the N sources of the well layer and the barrier layer, a step of stopping supply of NH₃ in the step of interrupting epitaxial growth and restarting supply of NH₃ in the step of forming the barrier layer can be omitted. Thus, a long-wavelength light emitting element having further enhanced light emission properties can be manufactured with simplified manufacturing steps.

A light emitting element in one aspect of the present invention is directed to the light emitting element manufactured by using the above method for manufacturing a light emitting element, wherein the light emitting element has a light emission wavelength of 450 nm or more.

According to the light emitting element in one aspect of the present invention, since the light emitting element is manufactured by using the above method for manufacturing a light emitting element, the light emitting element including a light emitting layer having a well layer that has a high composition of In can be manufactured. Thus, the light emitting element having a long wavelength of 450 nm or more can be realized.

A light emitting element in another aspect of the present invention is directed to the light emitting element manufactured by using the above method for manufacturing a light emitting element, wherein the well layer has a thickness of 1 nm or more and 10 nm or less.

According to the light emitting element in another aspect of the present invention, since the light emitting element is manufactured by using the above method for manufacturing a light emitting element, desorption ofN at the surface of the well layer can be suppressed. Thus, the light emitting element having the well layer having a large thickness of 1 nm or more and 10 nm or less, which cannot be achieved conventionally, can be achieved.

A light emitting element in still another aspect of the present invention is directed to the light emitting element manufactured by using the above method for manufacturing a light emitting element, wherein the light emitting element satisfies a relationship of 0.2333x-90<y<0.4284x-174, where y (nm) represents a full width at half maximum and x (nm) represents a light emission wavelength when an electric current passes through the light emitting element at 10 A/cm² or more.

According to the light emitting element in still another aspect of the present invention, the light emitting element is manufactured by using the above method for manufacturing a light emitting element. Since desorption ofN at the surface of the well layer can be suppressed, the full width at half maximum can be made small. Since the composition of In in the well layer can be increased, the wavelength can be lengthened. Thus, the light emitting element having both small full width at half maximum and long wavelength which satisfies the relationship of 0.2333x-90<y<0.4284x-174 can be realized.

### EFFECTS OF THE INVENTION

According to a method for manufacturing a light emitting element and the light emitting element in the present invention, a long-wavelength light emitting element having enhanced light emission properties can be realized.

### BRIEF DESCRIPTION OF THE DRAWINGS

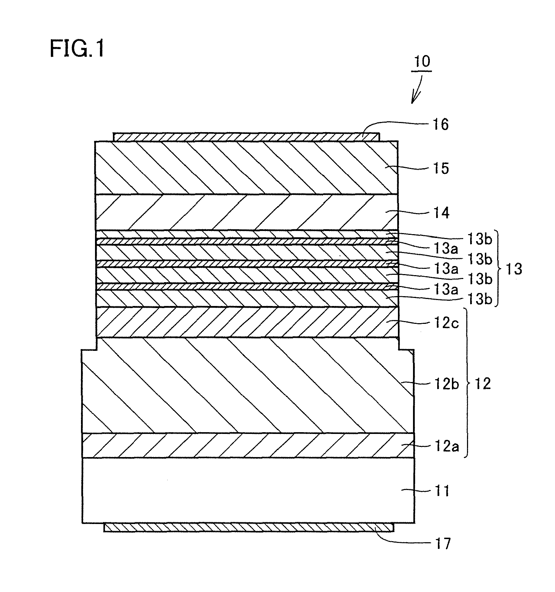

Fig. 1 is a cross-sectional view schematically illustrating an LED in a first embodiment of the present invention.

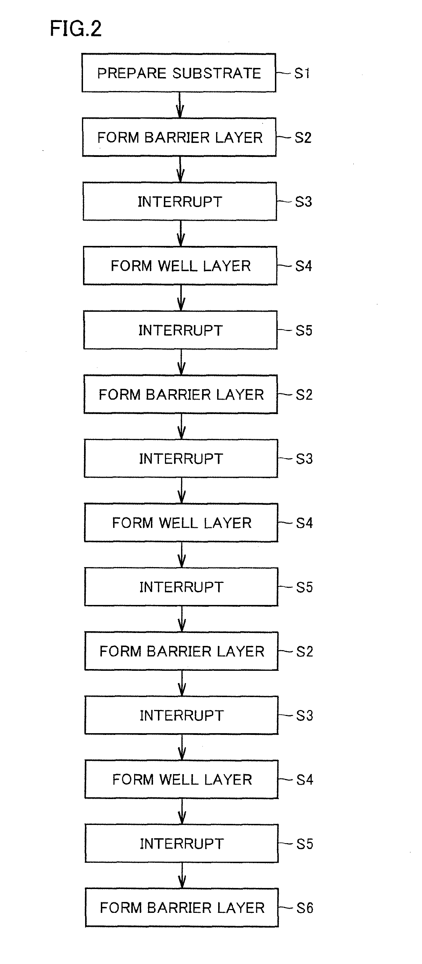

Fig. 2 is a flowchart of a method for manufacturing the LED in the first embodiment of the present invention.

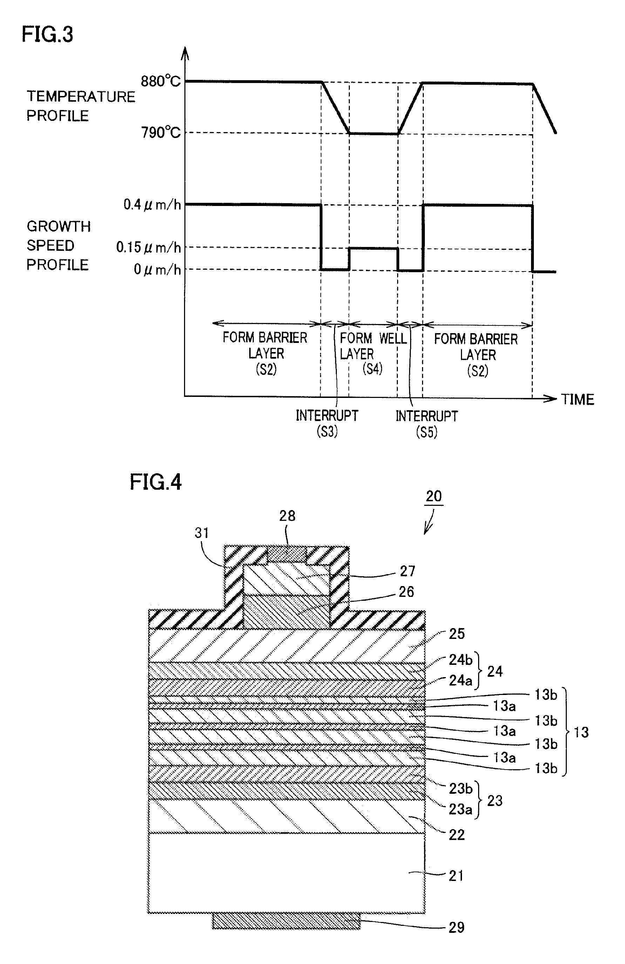

Fig. 3 is a schematic diagram for describing steps of forming an active layer in the first embodiment of the present invention.
Fig. 4 is a cross-sectional view schematically illustrating an LD in a second embodiment of the present invention.

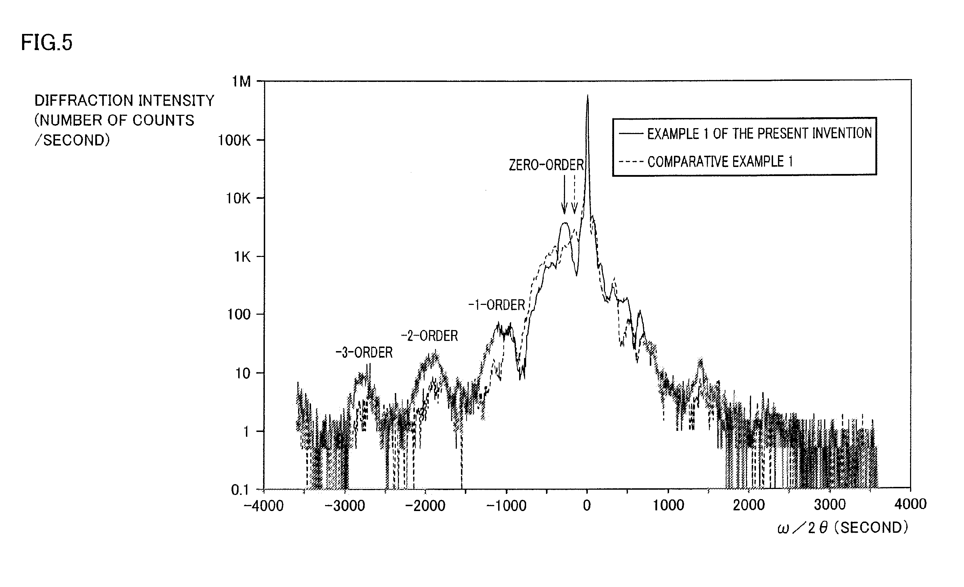

Fig. 5 illustrates the relationship between the angular position and the diffraction intensity in Example 1.

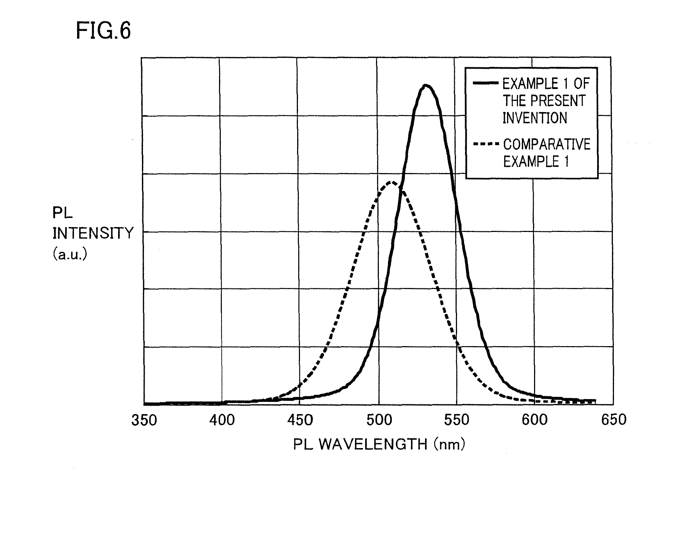

Fig. 6 illustrates the relationship between the PL wavelength and the PL intensity in Example 1.

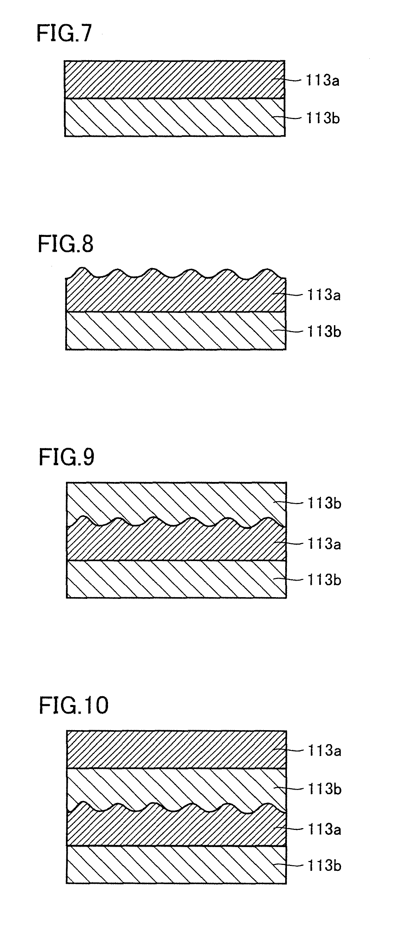

Fig. 7 is a cross-sectional view for describing a method for forming a light emitting layer having a quantum well structure including In and N disclosed in Patent Document 1.
Fig. 8 is a cross-sectional view for describing the method for forming a light emitting layer having a quantum well structure including In and N disclosed in Patent Document 1.
Fig. 9 is a cross-sectional view for describing the method for forming a light emitting layer having a quantum well structure including In and N disclosed in Patent Document 1.
Fig. 10 is a cross-sectional view for describing the method for forming a light emitting layer having a quantum well structure including In and N disclosed in Patent Document 1.

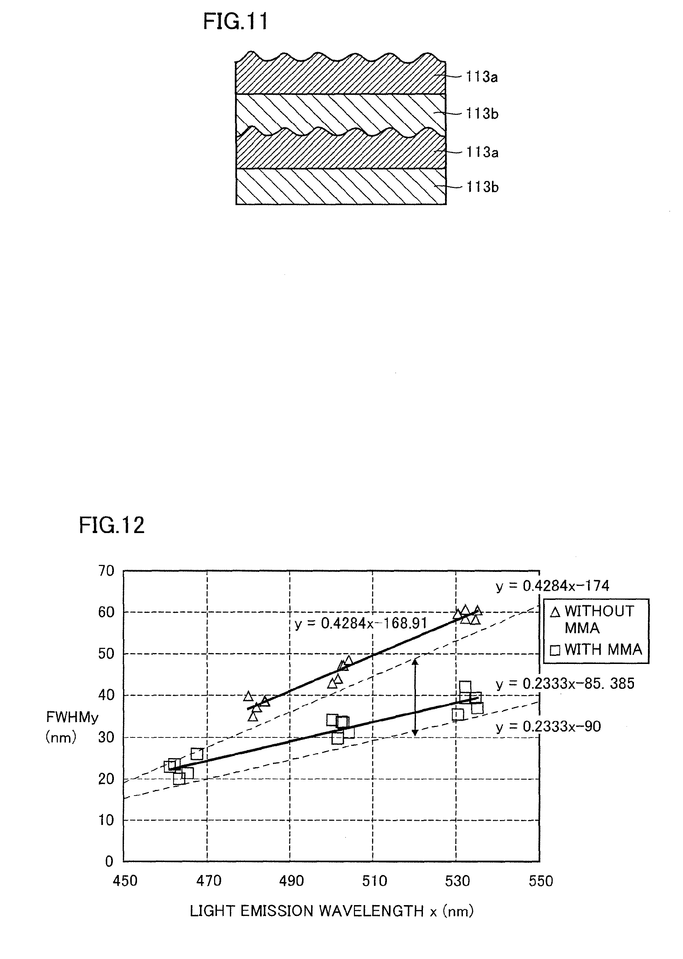

Fig. 11 is a cross-sectional view for describing the method for forming a light emitting layer having a quantum well structure including In and N disclosed in Patent Document 1.
Fig. 12 illustrates the relationship between the full width at half maximum and the light emission wavelength in Example 3.

### MODES FOR CARRYING OUT THE INVENTION

Embodiments of the present invention will be described hereinafter based on the drawings, wherein the same or corresponding portions are denoted with the same reference characters and description thereof will not be repeated.

### (First Embodiment)

Fig. 1 is a cross-sectional view schematically illustrating an LED that is one example of a light emitting element in a first embodiment of the present invention. The LED in the present embodiment will be described with reference to Fig. 1. An LED 10 in the present embodiment includes a substrate 11, an n-type buffer layer 12, an active layer 13, a p-type electron block layer 14, a p-type contact layer 15, a p-type electrode 16, and an n-type electrode 17.

Substrate 11 is, for example, an n-type GaN substrate. N-type buffer layer 12 includes a first layer 12a formed on substrate 11, a second layer 12b formed on first layer 12a, and a third layer 12c formed on second layer 12b. First layer 12a has a thickness of, for example, 50 nm and is made of n-type AlGaN. Second layer 12b has a thickness of, for example, 2000 nm and is made of n-type GaN. Third layer 12c has a thickness of, for example, 50 nm and is made of n-type GaN.

Active layer 13 is formed on n-type buffer layer 12 and has a quantum well structure in which a well layer 13a including In and N and a barrier layer 13b having a bandgap wider than that of well layer 13 a are stacked. In the present embodiment, barrier layers 13b are formed under the lowermost layer (a layer that is in contact with n-type buffer layer 12) of active layer 13 and on the uppermost layer (a layer that is in contact with p-type electron block layer 14) of active layer 13. Active layer 13 has a MQW (Multiple-Quantum Well) structure in which well layers 13a and barrier layers 13b are alternately stacked between lowermost barrier layer 13b and uppermost barrier layer 13b.

Well layer 13a has a thickness of, for example, 3 nm and is made of InGaN. Well layer 13a preferably has a thickness of 1 nm or more and 10 nm or less. When well layer 13a has a thickness of 1 nm or more, light emission having a wavelength of 450 nm or more can be readily obtained. When well layer 13a has a thickness of 10 nm or less, a well layer having high light emission efficiency and excellent crystal quality can be readily grown. Barrier layer 13b has a thickness of, for example, 15 nm and is made of GaN.

P-type electron block layer 14 is formed on active layer 13. P-type electron block layer 14 has a thickness of, for example, 20 nm and is made of p-type AlGaN.

P-type contact layer 15 is formed on p-type electron block layer 14. P-type contact layer 15 has a thickness of, for example, 50 nm and is made of p-type GaN.

P-type electrode 16 is formed on p-type contact layer 15 and has a feature of high transmittance. P-type electrode 16 may be configured by, for example, nickel (Ni) and gold (Au), or may be made of ITO (indium tin oxide) and the like. N-type electrode 17 is formed on the surface side of substrate 11 opposite to the surface where n-type buffer layer 12 is formed, and is made of, for example, titanium (Ti), Al and the like.

LED 10 has a light emission wavelength of 450 nm or more, and preferably 500 nm or more. When LED 10 has a wavelength of 450 nm or more, the composition of In in the InGaN well layer may decrease, and thus, the application of the present invention has great significance. When LED 10 has a wavelength of 500 nm or more, the composition of In in the InGaN well layer readily decreases, and thus, the application of the present invention has enormous significance. It is noted that the upper limit of the wavelength of LED 10 is, for example, 600 nm for manufacturing reasons.

In addition, LED 10 satisfies the relationship of 0.2333x-90<y<0.4284x-174, assuming that y (nm) represents the full width at half maximum and x (nm) represents the light emission wavelength when an electric current passes through LED 10 at 10 A/cm² or more. When 0.2333x-90<y, the full width at half maximum of almost ideal crystals is achieved. When y<0.4284x-174, the application of the present invention causes suppression of a decrease in composition of In and formation of a uniform well layer.

It is noted that the above light emission wavelength refers to a peak wavelength at which the light emission intensity is maximum (peak intensity) when the light emission spectrum at the passage of an electric current at a current density of, for example, 10 A/cm² is measured. In addition, the above full width at half maximum refers to a difference between two wavelengths that each provides a value of a half of the peak intensity.

Fig. 2 is a flowchart of a method for manufacturing LED 10 in the present embodiment. Referring to Figs. 1 and 2, the method for manufacturing LED 10 in the present embodiment will follow.

First, substrate 1 1 is prepared (step S1). In the present embodiment, an n-type GaN substrate, for example, is prepared as substrate 11.

Next, n-type buffer layer 12 is formed on substrate 11. In this step, above-described first layer 12a, second layer 12b and third layer 12c are formed in this order by using, for example, an MOCVD (Metal Organic Chemical Vapor Deposition) method.

Next, active layer 13 is formed on n-type buffer layer 12 (steps S2 to S6). Fig. 3 is a schematic diagram for describing steps of forming active layer 13 in the present embodiment. The steps of forming active layer 13 in the present embodiment will be described hereinafter with reference to Figs. 1 to 3.

First, as shown in Figs. 1 to 3, barrier layer 13b including N is formed on n-type buffer layer 12 (step S2). In this step S2, GaN is grown by using, for example, the MOCVD method. In addition, in step S2, barrier layer 13b is grown at a high temperature of, for example, 880°C in order to grow a layer having excellent crystallinity and optical properties. Ammonia, for example, is used as an N source of barrier layer 13b.

Thereafter, a gas including N is supplied and epitaxial growth is interrupted (step S3). In this step S3, supply of a material is stopped and the temperature is reduced to a temperature at which well layer 13a is grown. In this step S2, only a carrier gas may be flown, or not all gases may be flown, or another gas may be flown together with the carrier gas or instead of the carrier gas.

Then, well layer 13a including In and N is formed (step S4). In this step S4, InGaN is grown by using, for example, the MOCVD method. In addition, in step S4, well layer 13a is formed at a temperature (e.g., 790°C) lower than the temperature in step S2 of forming barrier layer 13b, because In that configures well layer 13a desorbs readily at the growth surface at a low temperature. It is noted that the growth temperature in step S4 of forming well layer 13a is lower than the growth temperature in step S2 of forming barrier layer 13b, and thus, the growth speed in step S4 is also low. Ammonia, for example, is used as an N source of well layer 13 a.

Thereafter, a gas including N is supplied and epitaxial growth is interrupted (step S5). In this step S5, the gas having decomposition efficiency higher than decomposition efficiency of decomposition from N₂ and NH₃ into the active nitrogen at 900°C is supplied. As a result, the effect of protecting well layer 13a can be strengthened and decomposition of In and N that configure well layer 13a can be suppressed.

The active nitrogen herein refers to N having a dangling bond, for example. Since N having a dangling bond readily reacts with other elements, dissociation of bonding between In and N can be suppressed or bonding between In and N separated at the surface of well layer 13a is possible. The decomposition efficiency can be determined by, for example, the constant of dissociation reaction into the active nitrogen, the bonding energy and the like. Since decomposition of In and N progresses, in particular, at 900°C or more, the gas having high efficiency of decomposition into the active nitrogen at 900°C is used.

The bonding energy into the active nitrogen that is one example of an indicator of the decomposition efficiency will be described in the following Table 1. In Table 1, a gas having small bonding energy is a gas having high decomposition efficiency.

**[Table 1]**

| Designation | Molecular Formula | Bonding | Bonding Energy (kJ/mol) 25°C |
|---|---|---|---|
| Nitrogen | N₂ | N≡N | 945 |
| Ammonia | NH₃ | N-H | 391 |
| Monomethylamine | CH₃-NH₂ | N-CH₃ | 273 |
| Dimethylamine | (CH₃)₂-N | N-CH₃ | 273 |
| Triethylamine | (CH₃)₃-N | N-CH₃ | 273 |
| Hydrazine | N₂H₄ | N-N | 158 |
| Dimethylhydrazine | (CH₃)₂N-NH₂ | N-N | 158 |
| Diethylhydrazine | (C₂H₅)NH-NH(C₂H₅) | N-N | 158 |

It is noted that as described in above Table 1, monomethylamine, dimethylamine and triethylamine have small bonding energy, as compared with nitrogen and ammonia. In addition, hydrazine, dimethylhydrazine and diethylhydrazine (hydrazine-based material) have smaller bonding energy, while the reactivity thereof is too high. Therefore, the hydrazine-based material has a problem of a decrease in growth speed caused by vapor phase reaction with an organic metal material. In addition, the hydrazine-based material has extremely high toxicity, as compared with ammonia and nitrogen. Therefore, the facilities cost for maintenance of safety is required, and thus, the hydrazine-based material is not appropriate for production. For this reason, monomethylamine, dimethylamine and triethylamine are preferably used as the gas having high decomposition efficiency.

In particular, in this step S5, a gas including at least one of monomethylamine and monoethylamine is preferably supplied as the gas having high decomposition efficiency. In the vapor phase, monomethylamine and monoethylamine can generate NH₂ having a dangling bond by using energy required to break one bonding between N and C (carbon). Since energy required for decomposition in the vapor phase into NH₂ having a dangling bond is small, the amount of heat required to supply the active nitrogen is small. Therefore, monomethylamine and monoethylamine can supply the active nitrogen at a low temperature.

In addition, a gas including ammonia and at least one of monomethylamine and monoethylamine having a concentration of a hundredth or less of a concentration of ammonia is preferably supplied. When ammonia is used as the N sources of well layer 13a and barrier layer 13b, the atmosphere including the active nitrogen can be achieved without stopping supply of ammonia that is a material for N.

Furthermore, in step S5 of interrupting epitaxial growth, a gas different from the gas used as the N sources of well layer 13a and barrier layer 13b is supplied. In the present embodiment, ammonia is used as the N sources of well layer 13a and barrier layer 13b, and in step S5 of interrupting epitaxial growth, a gas including ammonia and at least one of monomethylamine and monoethylamine is supplied. In this case, even if the conditions and the like for easy decomposition into the active nitrogen vary in step S5 of interrupting epitaxial growth, there is a higher probability that either ammonia or at least one of monomethylamine and monoethylamine included in the gas decomposes into the active nitrogen, and desorption ofN that configures well layer 13a can be suppressed.

Moreover, step S5 is preferably performed for one second or more. In this case, the temperature can be readily raised, and thus, manufacturing is easy.

In this step S5, since epitaxial growth is interrupted and the temperature is raised in the atmosphere including the active nitrogen, desorption ofN and In at the surface of well layer 13a can be suppressed. Therefore, the surface of well layer 13a can be flattened. In addition, the composition of In in well layer 13a can be maintained high. The composition of In is preferably 20 to 30%. With this composition, green light emission is obtained.

As described above, by forming barrier layer 13b (step S2), interrupting epitaxial growth to reduce the temperature (step S3), forming well layer 13a (step S4), and interrupting epitaxial growth to raise the temperature (step S5), a pair of barrier layer 13b and well layer 13a can be formed.

Similarly, by forming barrier layer 13b (step S2), interrupting epitaxial growth to reduce the temperature (step S3), forming well layer 13a (step S4), and interrupting epitaxial growth to raise the temperature (step S5), a plurality of pairs of barrier layers 13b and well layers 13a are formed.

As a result, active layer 13 including well layer 13a including In and N and barrier layer 13b having a bandgap wider than that of well layer 13a can be formed as shown in Fig. 1. It is noted that in the present embodiment, barrier layer 13b is formed to be located at the uppermost layer of active layer 13 (step S6).

Next, as shown in Fig. 1, p-type electron block layer 14 is formed on active layer 13. In this step, p-type AlGaN is grown by using, for example, the MOCVD method.

Next, p-type contact layer 15 is formed on p-type electron block layer 14. In this step, p-type GaN is grown by using, for example, the MOCVD method.

Next, p-type electrode 16 having high transmittance is formed on p-type contact layer 15. In this step, an electrode having, for example, Ni, Au, ITO and the like stacked is formed by using the vapor deposition method.

Next, n-type electrode 17 is formed on the surface side of substrate 1 1 opposite to the surface where n-type buffer layer 12 is formed. In this step, an electrode having, for example, Ti, Al and the like stacked is formed by using the vapor deposition method.

It is noted that when an n-type or p-type III-V group compound semiconductor is grown, a material including n-type impurities or a material including p-type impurities are used together with a V group material and organic metal that is a material for a III group element, under the conditions that a desired n-type or p-type carrier concentration is achieved. TMG (trimethylgallium), TMI (trimethylindium), TMA (trimethylaluminum) and the like, for example, can be used as the organic metal. Silane and the like, for example, can be used as the n-type impurities. Bis(cyclopentadienyl)magnesium and the like, for example, can be used as the p-type impurities. Nitrogen, hydrogen and the like, for example, can be used as the carrier gas.

By performing the above steps, LED 10 shown in Fig. 1 can be manufactured.

Although the III-V group compound semiconductor is grown by using the MOCVD method in the present embodiment, the method is not particularly limited thereto. A vapor phase growth method such as an HVPE (Hydride Vapor Phase Epitaxy) method and an MBE (Molecular Beam Epitaxy) method can be employed, for example. In addition, a plurality of these vapor phase growth methods may be combined.

In addition, the temperature may not be raised in step S5 of interrupting epitaxial growth after step S4 of forming well layer 13a and before steps S2 and S6 of forming barrier layer 13b. In other words, in step S5 of interrupting epitaxial growth, the temperature may be maintained constant. In this case as well, during switching from the material for forming well layer 13a to the material for forming barrier layer 13b, epitaxial growth is interrupted. Even if the temperature during interruption is low, In separates from N because bonding between In and N is weak. Therefore, in step S5 of interrupting epitaxial growth, at least one of supply of the gas having decomposition efficiency higher than decomposition efficiency of decomposition from N₂ and NH₃ into the active nitrogen at 900°C and supply of the gas different from the gas used as the N sources of well layer 13a and barrier layer 13b is performed.

Furthermore, step S3 of interrupting epitaxial growth after step S2 of forming barrier layer 13b and before step S4 of forming well layer 13a may not be provided.

Moreover, although LED 10 including the well layer made of InGaN and the barrier layer made of GaN has been described by way of example in the present embodiment, the light emitting element is not particularly limited thereto as long as it is a light emitting element of a III-V group compound semiconductor having a quantum well structure including In and N. The present invention is also applicable to a light emitting element including a well layer made of InₓGa₍₁₋ₓ₎As_{(1-y)}N_{y} (0<x<1, 0<y<1) and a barrier layer made of GaAs, for example.

As described above, according to the method for manufacturing LED 10 in the present embodiment, the gas having decomposition efficiency higher than decomposition efficiency of decomposition from N₂ and NH₃ into the active nitrogen at 900°C is supplied in step S5 of interrupting epitaxial growth. Since N₂ generally used as the carrier gas and NH₃ used as the V group material are relatively stable, decomposition into the active nitrogen is not promoted at 900°C or less that is the temperature at which active layer 13 is formed. In the present embodiment, the gas having decomposition efficiency higher than that of nitrogen and ammonia is supplied in step S5 of interrupting epitaxial growth, and thus, epitaxial growth can be interrupted in the atmosphere including the large amount of the active nitrogen. As a result, reaction of separation of In and N that configure well layer 13a can be suppressed. Furthermore, even when In and N that configure well layer 13a separate, N is taken into well layer 13a by the active nitrogen in the atmosphere. Therefore, desorption of N that configures well layer 13a in step S5 of interrupting epitaxial growth can be suppressed, and desorption of In caused by the desorption ofN can also be suppressed. Accordingly, formation of irregularities on the surface of well layer 13 a after well layer 13 a is formed and until barrier layer 13b is formed can be suppressed, and thus, light emission properties can be enhanced. In addition, since desorption ofN at the surface of well layer 13 a can be suppressed and agglomeration of In can be suppressed, agglomeration of a part of In as metal In can be suppressed. Therefore, a non-light-emitting region caused by blackening can be reduced, and thus, a decrease in light emission efficiency can be suppressed. Furthermore, a decrease in composition of In can be suppressed. Accordingly, active layer 13 including well layer 13a including InGaN that has a composition of In of, for example, 20 to 30% can be formed, and thus, long-wavelength green LED 10 can be manufactured.

In addition, when In decomposed from well layer 13a is included in the atmosphere, the active nitrogen can capture In in the atmosphere in step S5 of interrupting epitaxial growth. Therefore, take-in of unexpected In in steps S2 and S6 of forming barrier layer 13b after well layer 13a is formed can be suppressed.

Furthermore, in step S5 of interrupting epitaxial growth, dots of InGaN having a quantum size order that contributes to light emission can be formed in well layer 13a with enhanced uniformity. Therefore, the quantum effect due to formation of the dots can be promoted and variations in light emission wavelength between the respective dots can be suppressed. Therefore, LED 10 in which the full width at half maximum of the light emission wavelength can be made small and the light emission properties can be enhanced can be realized.

In the method for manufacturing LED 10 in the present embodiment, the temperature is preferably raised in step S5 of interrupting epitaxial growth. As a result, barrier layer 13b can also be formed at a high temperature. Therefore, the crystallinity and the optical properties of barrier layer 13b can also be enhanced.

### (Second Embodiment)

Fig. 4 is a cross-sectional view schematically illustrating an LD that is one example of a light emitting device in a second embodiment of the present invention. The LD in the present embodiment will be described with reference to Fig. 4. Specifically, as shown in Fig. 4, an LD 20 in the present example includes a substrate 21, an n-type clad layer 22, a guide layer 23, active layer 13, a guide layer 24, a p-type electron block layer 25, a p-type clad layer 26, a p-type contact layer 27, a p-type electrode 28, an n-type electrode 29, and an insulating film 31.

Substrate 21 is, for example, an n-type GaN substrate. N-type clad layer 22 is formed on substrate 21. N-type clad layer 22 has a thickness of, for example, 2.3 µm and is made of n-type AlGaN.

Guide layer 23 includes a first layer 23a formed on n-type clad layer 22, and a second layer 23b formed on first layer 23a. First layer 23a has a thickness of, for example, 200 nm and is made of n-type GaN. Second layer 23b has a thickness of, for example, 50 nm and is made of undoped InGaN.

Active layer 13 is formed on guide layer 23. Active layer 13 is similar to active layer 13 in the first embodiment, and thus, description thereof will not be repeated.

Guide layer 24 includes a first layer 24a formed on active layer 13, and a second layer 24a formed on first layer 24a. First layer 24a has a thickness of, for example, 50 nm and is made of undoped InGaN. Second layer 24b has a thickness of, for example, 200 nm and is made of undoped GaN.

P-type electron block layer 25 is formed on guide layer 24. P-type electron block layer 25 has a thickness of, for example, 20 nm and is made of p-type AlGaN.

P-type clad layer 26 is formed on p-type electron block layer 25. P-type clad layer 26 has a thickness of, for example, 0.4 µm and is made of p-type AlGaN.

P-type contact layer 27 is formed on p-type clad layer 26. P-type contact layer 27 has a thickness of, for example, 10 nm and is made of p-type GaN.

A mesa structure is formed by dry etching in a region other than a contact portion where p-type electrode 28 is in contact with p-type contact layer 27. SiO₂ (silicon dioxide), for example, is formed as insulating film 31 in the region other than the contact portion by using the vapor deposition method. P-type electrode 28 is formed on p-type contact layer 27 and is made of, for example, Ni, Au and the like. N-type electrode 29 is formed on the surface side of substrate 21 opposite to the surface where n-type clad layer 22 is formed. N-type electrode 29 is made of, for example, Ti, Al and the like.

Referring to Fig. 4, a method for manufacturing LD 20 in the present embodiment will follow. First, substrate 21 is prepared as in the first embodiment (step S1).

Next, n-type clad layer 22, guide layer 23, active layer 13, guide layer 24, p-type electron block layer 25, p-type clad layer 26, and p-type contact layer 27 are formed in this order on substrate 21 by using, for example, the MOCVD method. It is noted that steps S2 to S6 of forming active layer 13 are similar to those in the first embodiment, and thus, description thereof will not be repeated. In addition, the materials similar to those in the first embodiment can be used as the organic metal that is the III group material, the V group material, the n-type and p-type impurities, the carrier gas and the like.

Next, the mesa structure having a width of 2 µm and a depth of 0.4 µm is formed in the region other than the contact portion where p-type electrode 28 is in contact with p-type contact layer 27, by reactive ion etching with a Cl₂ (chlorine) gas, for example. After p-type electron block layer 25 is exposed at the surface, SiO_{2,} for example, is formed as insulating film 31 in the region other than the contact portion by using the vapor deposition method.

Next, p-type electrode 28 is formed on p-type contact layer 27, and n-type electrode 29 is formed on the surface side of substrate 11 opposite to the surface where n-type clad layer 22 is formed.

By performing the above steps, LD 20 shown in Fig. 4 can be manufactured. Since LD 20 includes active layer 13 similar to active layer 13 in the first embodiment, LD 20 that achieves a long-wavelength light emitting element having enhanced light emission properties can be realized.

### Example 1

In the present example, the effect of supplying the gas including N after step S4 of forming well layer 13a and before steps S2 and S6 of forming barrier layer 13b, and supplying the gas having decomposition efficiency higher than decomposition efficiency of decomposition from N₂ and NH₃ into the active nitrogen at 900°C in step S5 of interrupting epitaxial growth was examined. In addition, the effect of supplying the gas different from the gas used as the N sources of well layer 13a and barrier layer 13b in step S5 of interrupting epitaxial growth was examined.

### (Example 1 of the Present Invention)

In Example 1 of the present invention, an epitaxial wafer and LED 10 were manufactured by using the MOCVD method in accordance with the method for manufacturing an LED in the first embodiment.

Specifically, first, TMG, TMI and TMA were prepared as the III group material, ammonia was prepared as the V group material, SiH₄ (monosilane) was prepared as the n-type impurities, and monomethylamine was prepared as the gas supplied in step S5 of interrupting epitaxial growth.

The GaN substrate using a (0001) face as a main surface was prepared as substrate 11 (step S1). This substrate 11 was arranged on a susceptor within an MOCVD apparatus. Thereafter, ammonia and hydrogen were introduced into the MOCVD apparatus to do cleaning at 1050°C for 10 minutes, while the pressure in the MOCVD apparatus was controlled to 101 kPa.

Next, TMG, TMA, ammonia, and silane were introduced and n-type Al_{0.08}Ga_{0.92}N having a thickness of 50 nm was formed as first layer 12a on substrate 11 at 1050°C. Thereafter, an n-type GaN layer having a thickness of 2000 nm was formed as second layer 12b. Thereafter, the temperature was reduced to 800°C and an n-type In_{0.06}Ga_{0.94}N layer having a thickness of 50 nm was formed as third layer 12c. The growth speed of first layer 12a was 0.4 µm/h, the growth speed of second layer 12b was 4 µm/h, and the growth speed of third layer 12c was 0.15 µm/h.

Next, active layer 13 was formed on n-type buffer layer 12 (steps S2 to S6). Specifically, active layer 13 was grown to have the temperature profile and the growth speed profile as shown in Fig. 3. A method for forming active layer 13 will be described hereinafter.

First, barrier layer 13b having a thickness of 15 nm and made of GaN was formed on n-type buffer layer 12 (step S2). In this step S2, the growth temperature was 880°C, the growth speed was 0.4 µm/h, and the flow rate of ammonia was 29.6 slm.

Then, epitaxial growth was interrupted (step S3). In this step S3, the temperature was reduced from 880°C to 790°C for four minutes. At this time, ammonia was supplied at a flow rate of 29.6 slm.

Thereafter, well layer 13a having a thickness of 3 nm and made of InGaN having a composition ratio of In of about 20% was formed on barrier layer 13b (step S4). In this step S4, the growth temperature was 790°C, the growth speed was 0.15 µm/h, and the flow rate of ammonia was 29.6 slm.

Then, epitaxial growth was interrupted (step S5). In this step S5, the temperature was raised from 790°C to 880°C for three minutes. At this time, ammonia was supplied at a flow rate of 29.6 slm and monomethylamine was supplied at a flow rate of 3 sccm. Monomethylamine was merged with ammonia before being supplied into the MOCVD apparatus, and was supplied onto the susceptor. It is noted that monomethylamine has decomposition efficiency higher than decomposition efficiency of decomposition from N₂ and NH₃ into the active nitrogen at 900°C.

Thereafter, the above steps S2 to S5 were repeated three times. As a result, a triple quantum well structure was formed. Furthermore, barrier layer 13b having a thickness of 10 nm and made of GaN was formed (step S6). In this step S6, the growth temperature was 880°C, and the growth speed was 0.4 µm/h. As a result, barrier layer 13b located at the uppermost layer of active layer 13 was formed. As described above, active layer 13 was formed.

Next, the temperature of substrate 1 1 was raised to 1000°C and p-type Al_{0.08}Ga_{0.92}N having a thickness of 20 nm was formed as p-type electron block layer 14 on active layer 13.

Subsequently, p-type GaN having a thickness of 50 nm was formed as p-type contact layer 15 on p-type electron block layer 14.

Thereafter, the temperature in the MOCVD apparatus was reduced and the epitaxial wafer for a III-V group semiconductor was taken out of the MOCVD apparatus. The epitaxial wafer of Example 1 of the present invention was manufactured through the above steps.

Next, the translucent electrode having Ni and Au stacked was formed as p-type electrode 16 on p-type contact layer 15 by using the vapor deposition method. Next, the electrode having Ti, Al and the like stacked was formed as n-type electrode 17 on the surface side of substrate 11 opposite to the surface where n-type buffer layer 12 was formed, by using the vapor deposition method.

In addition, the mesa structure was formed in the epitaxial wafer. Specifically, a photolithography method was used for mesa pattern formation and the RIE (Reactive Ion Etching) method was used for mesa formation.

LED 10 of Example 1 of the present invention having a size of 400 µm x 400 µm was manufactured through the above steps.

### (Comparative Example 1)

In Comparative Example 1, the epitaxial wafer and the LED were manufactured basically similarly to Example 1 of the present invention. Comparative Example 1 was, however, different from Example 1 of the present invention only in that only ammonia was supplied without supplying monomethylamine in step S5 of interrupting epitaxial growth.

### (Result of Evaluation)

By X-ray diffraction, the composition of In in the well layer was examined for the epitaxial wafers of Example 1 of the present invention and Comparative Example 1. An X-ray source was CuKα1 and the entrance slit size was set to 0.2 mm x 2.0 mm. In addition, diffraction at a (0002) face was measured by using a ω-2θ method. The result is shown in Fig. 5. It is noted that Fig. 5 illustrates the relationship between the angular position (ω/2θ) and the diffraction intensity in the present example. In Fig. 5, the horizontal axis indicates ω/2θ (unit: second) and the vertical axis indicates the diffraction intensity (unit: number of counts/second). In Fig. 5, the average composition of In in the MQW was obtained and the average composition of In in the well layer was estimated, based on the zero-order satellite peak position caused by the MQW of the active layer.

Consequently, the composition of In was 0.18 in the epitaxial wafer of Example 1 of the present invention in which monomethylamine was supplied in step S5 of interrupting epitaxial growth. On the other hand, the composition of In was 0.14 in the epitaxial wafer of Comparative Example 1 in which only ammonia was supplied without supplying monomethylamine in step S5 of interrupting epitaxial growth.

This result showed that, by supplying monomethylamine having decomposition efficiency higher than decomposition efficiency of decomposition from N₂ and NH₃ into the active nitrogen at 900°C, or by supplying monomethylamine that is a gas different from ammonia used as the N sources of well layer 13a and barrier layer 13b, in step S5 of interrupting epitaxial growth, the effect of protecting well layer 13a was strengthened and decomposition of In and N was able to be suppressed.

In addition, as shown in Fig. 5, when attention was focused on the low-angle side of the satellite peak intensity caused by the MQW, the diffraction intensity was observed more clearly in Example 1 of the present invention in which monomethylamine was supplied in step S5 of interrupting epitaxial growth than in Comparative Example 1 in which monomethylamine was not supplied. This fact showed that by supplying monomethylamine having decomposition efficiency higher than decomposition efficiency of decomposition from N₂ and NH₃ into the active nitrogen at 900°C, or by supplying monomethylamine that is a gas different from ammonia used as the N sources of well layer 13a and barrier layer 13b, the interfacial steepness was able to be increased.

Furthermore, by using a photoluminescence method, the light emission wavelength, the light emission intensity, the full width at half maximum, and the light emission spectrum were evaluated for the epitaxial wafers of Example 1 of the present invention and Comparative Example 1. An He (helium)-Cd (cadmium) laser having a wavelength of 325 nm was used as an excitation laser. The excitation density was set to 2 W/cm². Measurement was carried out at a room temperature. The result is shown in Table 2 and Fig. 6. It is noted that Fig. 6 illustrates the relationship between the PL wavelength and the PL intensity in the present example. In Fig. 6, the horizontal axis indicates the PL wavelength (unit: nm) and the vertical axis indicates the PL intensity (unit: a.u.).

**[Table 2]**

| | Light Emission Wavelength (nm) | Light Emission Intensity (Standardized) | Full Width at Half Maximum (nm) |
|---|---|---|---|
| Example 1 of the Present Invention | 531 | 1 | 44 |
| Comparative Example 1 | 509 | 0.7 | 60 |

As shown in Table 2 and Fig. 6, the light emission wavelength was longer, the light emission intensity was higher, and the full width at half maximum was smaller in Example 1 of the present invention than in Comparative Example 1. This fact showed that by supplying monomethylamine in step S5 of interrupting epitaxial growth, the effect of protecting well layer 13a was strengthened and decomposition of In and N was able to be suppressed.

Furthermore, the light output when an electric current passes through the LED at 75 A/cm² was measured, thereby measuring the light emission wavelength, the light emission intensity and the full width at half maximum for the LEDs of Example 1 of the present invention and Comparative Example 1. The result is shown in the following Table 3. Values in Table 3 indicate intermediate values in the LED. It is noted that in Table 3, the amount of blue shift was obtained from a difference with the light emission wavelength when an electric current passes through the LED at 1 A/cm².

**[Table 3]**

| | Light Emission Wavelength (nm) | Light Emission Output (mW) | Amount of Blue Shift (nm) | Full Width at Half Maximum (nm) |
|---|---|---|---|---|
| Example 1 of the Present Invention | 505 | 10.1 | 26 | 43 |
| Comparative Example 1 | 481 | 8.5 | 28 | 48 |

As shown in Table 3, the light emission wavelength was longer in Example 1 of the present invention than in Comparative Example 1, and thus, the LED of Example 1 of the present invention was found to be advantageous to lengthening of the wavelength.

In addition, the light emission output was stronger in Example 1 of the present invention than in Comparative Example 1, and thus, the LED of Example 1 of the present invention was found to be advantageous to making the output high.

Furthermore, the amount of blue shift was smaller in Example 1 of the present invention than in Comparative Example 1, and thus, fluctuations in bandgap of well layer 13a was found to be small and the steepness was found to be good.

Moreover, the full width at half maximum was narrower in Example 1 of the present invention than in Comparative Example 1, and thus, fluctuations in bandgap of well layer 13a was found to be small and the steepness was found to be good.

These facts showed that by supplying monomethylamine in step S5 of interrupting epitaxial growth, decomposition in well layer 13a during interruption of growth between growth of well layer 13a and growth of barrier layer 13b was able to be suppressed and the interfacial steepness was improved.

As described above, according to the present example, it was found that by supplying the gas having decomposition efficiency higher than decomposition efficiency of decomposition from N₂ and NH₃ into the active nitrogen at 900°C, or by supplying the gas different from the gas used as the N sources of well layer 13a and barrier layer 13b, in step S5 of interrupting epitaxial growth, a long-wavelength LED having enhanced light emission properties was able to be realized.

### Example 2

In the present example, the effect of supplying the gas including N after step S4 of forming well layer 13a and before steps S2 and S6 of forming barrier layer 13b, and supplying the gas having decomposition efficiency higher than decomposition efficiency of decomposition from N₂ and NH₃ into the active nitrogen at 900°C in step S5 of interrupting epitaxial growth was examined. In addition, the effect of supplying the gas different from the gas used as the N sources of well layer 13a and barrier layer 13b in step S5 of interrupting epitaxial growth was examined.

### (Example 2 of the Present Invention)

In Example 2 of the present invention, the epitaxial wafer and LD 20 were manufactured by using the MOCVD method in accordance with the method for manufacturing an LD in the second embodiment.

Specifically, first, the materials were prepared as in Example 1 of the present invention. In addition, the GaN substrate using the (0001) face as the main surface was prepared as substrate 11 as in Example 1 of the present invention (step S1).

Next, TMG, TMA, ammonia, and monosilane were introduced and n-type Al_{0.04}Ga_{0.96}N having a thickness of 2300 nm was formed as n-type clad layer 22 on substrate 21 at 1050°C.

Next, n-type GaN having a thickness of 200 nm was formed as first layer 23a. Thereafter, the temperature was reduced to 800°C and an undoped In_{0.05}Ga_{0.9}sN layer having a thickness of 50 nm was formed as second layer 23b. As a result, guide layer 23 was formed.

Next, active layer 13 was formed on guide layer 23 (steps S2 to S6). Specifically, active layer 13 was grown as will be described hereinafter.

First, barrier layer 13b having a thickness of 15 nm and formed of an In_{0.04}Ga_{0.96}N layer was formed on guide layer 23 (step S2). In this step S2, the growth temperature was 880°C, the growth speed was 0.4 µm/h, and the flow rate of ammonia was 29.6 slm.

Then, epitaxial growth was interrupted (step S3). In this step S3, the temperature was reduced from 880°C to 790°C for four minutes. At this time, ammonia was supplied at a flow rate of 29.6 slm.

Thereafter, well layer 13a having a thickness of 3 nm and made of In_{0.25}Ga_{0.75}N was formed on barrier layer 13b (step S4). In this step S4, the growth temperature was 790°C, the growth speed was 0.15 µm/h, and the flow rate of ammonia was 29.6 slm.

Then, epitaxial growth was interrupted (step S5). In this step S5, the temperature was raised from 790°C to 880°C for three minutes. At this time, ammonia was supplied at a flow rate of 29.6 slm and monomethylamine was supplied at a flow rate of 3 sccm.

Thereafter, the above steps S2 to S5 were repeated three times. As a result, a triple quantum well structure was formed. Furthermore, barrier layer 13b having a thickness of 50 nm and made of In_{0.05}Ga_{0.95}N was formed (step S6). In this step S6, the growth temperature was 880°C, and the growth speed was 0.4 µm/h. As a result, barrier layer 13b located at the uppermost layer of active layer 13 was formed.

Next, p-type In_{0.05}Ga_{0.95}N having a thickness of 50 nm was formed as first layer 24a of guide layer 24 on active layer 13. Thereafter, the temperature of substrate 11 was raised to 1000°C and p-type GaN having a thickness of 200 nm was formed as second layer 24b.

Subsequently, Mg-doped p-type Al_{0.18}Ga_{0.82}N having a thickness of 20 nm was formed as p-type electron block layer 25 on guide layer 24. Thereafter, p-type Al_{0.06}Ga_{0.94}N having a thickness of 400 nm was formed as p-type clad layer 26. Next, p-type GaN having a thickness of 10 nm was formed as p-type contact layer 27.

Thereafter, the temperature in the MOCVD apparatus was reduced and the epitaxial wafer for the III-V group semiconductor was taken out of the MOCVD apparatus. The epitaxial wafer of Example 2 of the present invention was manufactured through the above steps.

Next, a ridge having a width of 2 µm was formed by using the RIE method. Thereafter, an insulating layer made of SiO₂ was formed by using a plasma CVD (Chemical Vapor Deposition) method. Next, the electrode having Ni and Au stacked was formed as p-type electrode 16 by using the vapor deposition method. Next, the surface of substrate 11 opposite to the surface where n-type clad layer 22 was formed was polished such that substrate 11 had a thickness of 100 µm. The electrode having Ti, Al and the like stacked was formed as n-type electrode 17 on this surface by using the vapor deposition method.

Finally, an m face was cleaved and LD 20 of Example 2 of the present invention having a resonator length of 600 µm was manufactured.

### (Comparative Example 2)

In Comparative Example 2, the epitaxial wafer and the LD were manufactured basically similarly to Example 2 of the present invention. Comparative Example 2 was, however, different from Example 2 of the present invention only in that only ammonia was supplied without supplying monomethylamine in step S5 of interrupting epitaxial growth.

### (Result of Evaluation)

The light emission wavelength and the threshold current density were measured for the LEDs of Example 2 of the present invention and Comparative Example 2. The result is shown in the following Table 4. The light emission wavelength was measured as in Example 1. The threshold current density was defined as the current density at which the light emission intensity started to increase linearly when the current density dependency of the light emission output was measured.

**[Table 4]**

| | Light Emission Wavelength (nm) | Threshold Current Density (kA/cm²) |
|---|---|---|
| Example 2 of the Present Invention | 521 | 15 |
| Comparative Example 2 | 500 | not lase |

As shown in Table 4, the LD of Comparative Example 2 did not lase, whereas the LD of Example 2 of the present invention lased. In addition, the light emission wavelength was longer in Example 2 of the present invention than in Comparative Example 2, and thus, the LD of Example 2 of the present invention was found to be advantageous to lengthening of the wavelength.

These facts showed that by supplying monomethylamine in step S5 of interrupting epitaxial growth, decomposition in well layer 13a during interruption of growth between growth of well layer 13a and growth of barrier layer 13b was able to be suppressed, and thus, a long-wavelength LD having enhanced light emission properties was able to be realized.

### Example 3

A plurality of LEDs having different wavelengths were fabricated through the above-described process in Example 1, and the full width at half maximum of the light emission spectrum when an electric current passes through the LEDs at 10 A/cm² was examined. Data about a sample fabricated with supply of monomethylamine was compared with data about a sample fabricated with supply of only ammonia.

Fig. 12 is a graph in which the vertical axis indicates the full width at half maximum y of the light emission spectrum and the horizontal axis indicates the light emission wavelength x. In the sample (with MMA) fabricated with supply of monomethylamine, y=0.2333x-85.385 was obtained as a result of straight-line approximation of the data. On the other hand, in the sample (without MMA) fabricated with supply of only ammonia, y=0.4284x-168.91 was obtained as a result of straight-line approximation of the data.

This fact showed that by fabricating the sample with supply of monomethylamine, the full width at half maximum became small. In addition, the longer the wavelength was, the larger a difference between the data about both samples was. Therefore, it was found that as the wavelength of a region became long, the effect of supplying monomethylamine became more significant. It was found that by taking ±3 to 5%, which is a typical value of chip-to-chip variations, into consideration and quantifying the full width at half maximum in the above straight-line approximate equations, and using monomethylamine, a light emitting element having both small full width at half maximum and long wavelength which satisfies the relationship of 0.2333x-90<y<0.4284x-174 was able to be realized. In other words, it was found that by supplying monomethylamine, a small full width at half maximum and a long wavelength in a region shown by an arrow in Fig. 12 was obtained.

Although the embodiments and examples of the present invention have been described above, combination as appropriate of features in each embodiment and example is originally encompassed. In addition, it should be understood that the embodiments and examples disclosed herein are illustrative and not limitative in any respect. The scope of the present invention is defined by the terms of the claims, rather than the above embodiments and examples, and is intended to include any modifications within the scope and meaning equivalent to the terms of the claims.

### DESCRIPTION OF THE REFERENCE SIGNS

10 LED; 11, 21 substrate; 12 n-type buffer layer; 12a, 23a, 24a first layer; 12b, 23b, 24b second layer; 12c third layer; 13 active layer; 13a well layer; 13b barrier layer; 14 p-type electron block layer; 15, 27 p-type contact layer; 16, 28 p-type electrode; 17, 29 n-type electrode; 20 LD; 22 n-type clad layer; 23, 24 guide layer; 25 p-type electron block layer; 26 p-type clad layer; 31 insulating film

## Claims

1. A method for manufacturing a light emitting element (10, 20) of a III-V group compound semiconductor having a quantum well structure including In and N, comprising the steps of:
forming a well layer (13a) including In and N;
forming a barrier layer (13b) including N and having a bandgap wider than a bandgap of said well layer (13 a); and
interrupting epitaxial growth by supplying a gas including N after said step of forming the well layer (13a) and before said step of forming the barrier layer (13b), wherein
in said step of interrupting epitaxial growth, said gas having decomposition efficiency higher than decomposition efficiency of decomposition from N₂ and NH₃ into active nitrogen at 900°C is supplied.

2. A method for manufacturing a light emitting element (10, 20) of a III-V group compound semiconductor having a quantum well structure including In and N, comprising the steps of:
forming a well layer (13a) including In and N;
forming a barrier layer (13b) including N and having a bandgap wider than a bandgap of said well layer (13a); and
interrupting epitaxial growth by supplying a gas including N after said step of forming the well layer (13a) and before said step of forming the barrier layer (13b), wherein
in said step of interrupting epitaxial growth, said gas different from a gas used as N sources of said well layer (13a) and said barrier layer (13b) is supplied.

3. The method for manufacturing a light emitting element (10, 20) according to claim 1, wherein
in said step of interrupting epitaxial growth, said gas including at least one of monomethylamine and monoethylamine is supplied.

4. The method for manufacturing a light emitting element (10, 20) according to claim 3, wherein
in said step of interrupting epitaxial growth, said gas including ammonia and at least one of monomethylamine and monoethylamine having a concentration of a hundredth or less of a concentration of ammonia is supplied.

5. A light emitting element (10, 20) manufactured by using the method for manufacturing a light emitting element (10, 20) according to claim 1, wherein
said light emitting element (10, 20) has a light emission wavelength of 450 nm or more.

6. A light emitting element (10, 20) manufactured by using the method for manufacturing a light emitting element according to claim 1, wherein
said well layer (13a) has a thickness of 1 nm or more and 10 nm or less.

7. A light emitting element (10, 20) manufactured by using the method for manufacturing a light emitting element according to claim 1, wherein
said light emitting element (10, 20) satisfies a relationship of 0.2333x-90<y<0.4284x-174, where y (nm) represents a full width at half maximum and x (nm) represents a light emission wavelength when an electric current passes through said light emitting element (10, 20) at 10 A/cm² or more.
